# EUROPEAN PATENT APPLICATION

(11) **EP 3 460 491 A1**
(43) Date of publication of application: **27.03.2019**
(21) Application number: 17192528.2
(22) Date of filing: 22.09.2017
(51) Int. Cl.: G01R 19/28

(54) **AN APPARATUS FOR MEASURING VOLTAGE OF THE ANTENNA FEED LINE**

(71) Applicant: Nokia Technologies Oy, 02610 Espoo (FI)
(72) Inventor: Ilmonen, Matias, 91900 Liminka (FI)
(74) Representative: Nokia EPO representatives

(57) **Abstract**

An apparatus (10), for connection in-line with an antenna feed line (20), comprising:
a first port (31) for connection to a first portion (21) of the antenna feed line;
a second port (32) for connection to a second portion (22) of the antenna feed line;
an antenna feed line portion (40) connected between the first port and the second port; and
monitoring circuitry (50) adjacent the antenna feed line portion and configured to measure voltage of the antenna feed line.

## Description

### TECHNOLOGICAL FIELD

Embodiments of the present invention relate to an apparatus for measuring voltage of the antenna feed line.

### BACKGROUND

It is sometimes desirable to measure voltage of an antenna feed line. The voltage depends upon a voltage standing wave ratio (VSWR) on the antenna line and is a useful indicator of antenna performance.

It may be difficult to position a coupler for measuring voltage of the antenna feed line at a suitable position so that it is correctly aligned with the antenna feed line.

It may be difficult to position a coupler for measuring voltage of the antenna feed line at a fixed spatial relationship from the antenna feed line.

It may be difficult to measure the voltage of the antenna feed line without occupying space needed by other components

### BRIEF SUMMARY

According to various, but not necessarily all, embodiments of the invention there is provided an apparatus, for connection in-line with an antenna feed line, comprising:
a first port for connection to a first portion of the antenna feed line;
a second port for connection to a second portion of the antenna feed line;
an antenna feed line portion connected between the first port and the second port; and
monitoring circuitry adjacent the antenna feed line portion and configured to measure voltage of the antenna feed line.

According to various, but not necessarily all, embodiments of the invention there is provided examples as claimed in the appended claims.

### BRIEF DESCRIPTION

For a better understanding of various examples that are useful for understanding the detailed description, reference will now be made by way of example only to the accompanying drawings in which:
Fig 1 illustrates an example of an apparatus, for connection in-line with an antenna feed line to measure voltage of the antenna feed line;
Figs 2A and 2B illustrates an example of an apparatus, for connection in-line with an antenna feed line to measure voltage of the antenna feed line;
Figs 3 and 4 illustrates an example of an apparatus, for connection in-line with an antenna feed line to measure voltage of the antenna feed line;
Fig 5 illustrates an example of a base station, for radio communication, comprising an example of an apparatus, for connection in-line with an antenna feed line to measure voltage of the antenna feed line.

### DETAILED DESCRIPTION

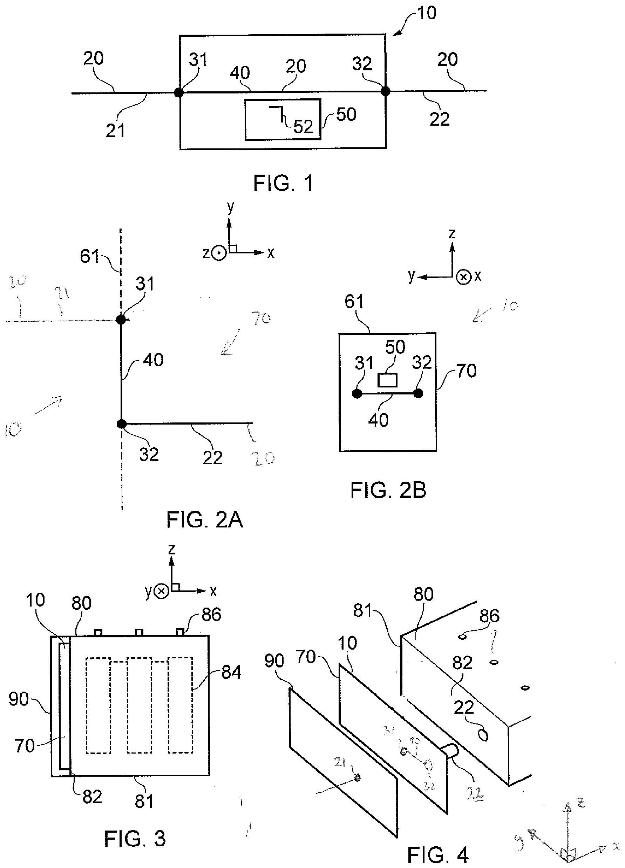

Fig 1 illustrates an example of an apparatus 10, for connection with an antenna feed line 20 to measure voltage of the antenna feed line 20.

The apparatus 10 comprises: a first port 31 for connection to a first portion 21 of the antenna feed line 20; a second port 32 for connection to a second portion 22 of the antenna feed line 20; an antenna feed line portion 40 connected between the first port 31 and the second port 32; and monitoring circuitry 50 adjacent the antenna feed line portion 40 and configured to measure voltage of the antenna feed line 20.

The first port 31 may be configured to connect to the first portion 21 of the antenna feed line 20. It may for example be a surface mounted connector on an exterior of the apparatus 10. The second port 32 may be configured to connect to the second portion 22 of the antenna feed line 20. It may for example be a surface mounted connector on an exterior of the apparatus 10.

The antenna feed line portion 40 connected between the first port 31 and the second port 32 may be a transmission line or part of a transmission line.

The monitoring circuitry 50 may comprise a coupler 52 adjacent but not in contact with the antenna feed line portion 40 and configured to measure voltage of the antenna feed line 20. The coupler 52 enables measurement of a voltage of the antenna feed line 20 dependent upon voltage standing wave ratio (VSWR).

In this example, the first port 31 and the second port 32 are aligned and the antenna feed line portion 40 is straight. In other examples, the first port 31 and the second port 32 are off-set. The antenna feed line portion 40 is not always straight. However, in both circumstances the apparatus 10 is connected functionally in-line with the antenna feed line 20 to measure voltage of the antenna feed line 20. The term 'in-line' should be understood in this context as functionally in series rather than geometrically aligned.
Figs 2A and 2B illustrates an example of an apparatus 10, for connection in-line with an antenna feed line 20 to measure voltage of the antenna feed line 20, similar to that illustrated in Fig 1 and similar references are used for similar features. Fig 2A illustrates a cross-sectional view along a x-y plane. Fig 2B illustrates a plan view of a y-z plane.

In this example, the first port 31, the second port 32, the antenna feed line portion 40 and the monitoring circuitry 50 are arranged substantially in a first plane 61 (y-z plane). The first plane 61 is substantially normal (orthogonal) to both the first portion 21 of the antenna feed line 20 and the second portion 22 of the antenna feed line 20.

In this example, the first port 31 and the second port 32 are positionally offset in a first direction (y) and the antenna feed line portion 40 connected from the first port 31 to the second port 32 extends in the first direction (y) in a negative sense (-y). The monitoring circuitry 50 is adjacent the antenna feed line portion 40 and offset from it in a second direction (z) orthogonal to the first direction (y). The first portion 21 of the antenna feed line 20 and the second portion 22 of the antenna feed line 20 extend in a third direction (x) orthogonal to the first and second directions (z=x^y). The first portion 21 of the antenna feed line 20 extends towards the first port 31 in a positive sense (+x). The second portion 22 of the antenna feed line 20 extends away from the second port 32 in a positive sense (+x).
In the example illustrated in Figs 2A and 2B, but not necessarily all examples, the apparatus 10 is configured as a printed circuit board 70 comprising the first port 31, the second port 32, the antenna feed line portion 40 and the monitoring circuitry 50. In use, the printed circuit board 70 extends along a first plane 61 (y-z plane) substantially normal to both the first portion 21 of the antenna feed line 20 and the second portion 22 of the antenna feed line 20.

Figs 3 and 4 illustrates an example of an apparatus 10, for connection in-line with an antenna feed line 20 to measure voltage of the antenna feed line 20, similar to that illustrated in Fig 1 and 2A & 2B and similar references are used for similar features.

The apparatus 10 is configured for connection to an exterior portion 82 of a housing 81 of a filter 80. In this example, but not necessarily all examples, the filter 80 comprises filter cavities 84 and the first portion 21 of the antenna feed line 20 and the second portion 22 of the antenna feed line 20 lie in a second plane (y-x plane) that transects the cavities 84 of the filter 80.

The first port 31, the second port 32, the antenna feed line portion 40, and the monitoring circuitry 50 adjacent the antenna feed line portion 40 are located between the exterior portion 82 of the housing 81 of the filter 80 and an isolating cover portion 90.

The first port 31, the second port 32, the antenna feed line portion 40, and the monitoring circuitry 50 adjacent the antenna feed line portion 40 lie in a first plane (y-z plane).

Manual tuning elements 86 of the filter 80 may, in some examples, be arranged substantially in a plane parallel to the second plane (x-y plane).

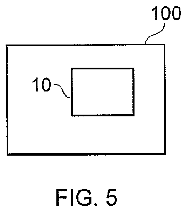

Fig 5 illustrates an example of a base station 100, for radio communication, comprising an example of an apparatus 10, for connection in-line with an antenna feed line 20 to measure voltage of the antenna feed line 20, similar to that illustrated in Figs 1-4 and similar references are used for similar features. In this example, the first plane 61 (y-z plane) is vertical and the second plane (x-y plane) is horizontal.

Consequently in at least some examples, the first port 31, the second port 32, the antenna feed line portion 40, and the monitoring circuitry 50 adjacent the antenna feed line portion 40 are located within a vertical plane 61, in use. The base station 100 may comprise a filter 80 comprising manual tuning elements 86 arranged substantially in a horizontal plane (x-y plane).

It will be appreciated from the foregoing that in at least some examples there is provided a method of measuring voltage of the antenna feed line 20 comprising: placing a component in-line with the antenna feed line 20, wherein the component provides a portion of the antenna feed line 20 and also provides monitoring circuitry 50 adjacent the portion of the antenna feed line 20 configured to measure voltage of the antenna feed line 20.

As used in this application, the term 'circuitry' refers to all of the following:
(a) hardware-only circuit implementations (such as implementations in only analog and/or digital circuitry) and
(b) to combinations of circuits and software (and/or firmware), such as (as applicable):
   (i) to a combination of processor(s) or (ii) to portions of processor(s)/software (including digital signal processor(s)), software, and memory(ies) that work together to cause an apparatus, such as a mobile phone or server, to perform various functions and
(c) to circuits, such as a microprocessor(s) or a portion of a microprocessor(s), that require software or firmware for operation, even if the software or firmware is not physically present.

This definition of 'circuitry' applies to all uses of this term in this application, including in any claims. As a further example, as used in this application, the term "circuitry" would also cover an implementation of merely a processor (or multiple processors) or portion of a processor and its (or their) accompanying software and/or firmware. The term "circuitry" would also cover, for example and if applicable to the particular claim element, a baseband integrated circuit or applications processor integrated circuit for a mobile phone or a similar integrated circuit in a server, a cellular network device, or other network device.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one.." or by using "consisting".

In this brief description, reference has been made to various examples. The description of features or functions in relation to an example indicates that those features or functions are present in that example. The use of the term 'example' or 'for example' or 'may' in the text denotes, whether explicitly stated or not, that such features or functions are present in at least the described example, whether described as an example or not, and that they can be, but are not necessarily, present in some of or all other examples. Thus 'example', 'for example' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example but does not necessarily have to be used in that other example.

Although embodiments of the present invention have been described in the preceding paragraphs with reference to various examples, it should be appreciated that modifications to the examples given can be made without departing from the scope of the invention as claimed.

In the example illustrated in Fig 4, the antenna feed line portion 40 extends from the first port 31 to the second port 32 with direction and sense -y. In other examples, the apparatus 10 may be rotated by 180° about the x-axis, in which case the antenna feed line portion 40 extends from the first port 31 to the second port 32 with direction and sense +y.

Features described in the preceding description may be used in combinations other than the combinations explicitly described.

Although functions have been described with reference to certain features, those functions may be performable by other features whether described or not.

Although features have been described with reference to certain embodiments, those features may also be present in other embodiments whether described or not.

Whilst endeavoring in the foregoing specification to draw attention to those features of the invention believed to be of particular importance it should be understood that the Applicant claims protection in respect of any patentable feature or combination of features hereinbefore referred to and/or shown in the drawings whether or not particular emphasis has been placed thereon.

## Claims

1. An apparatus, for connection in-line with an antenna feed line, comprising:
a first port for connection to a first portion of the antenna feed line;
a second port for connection to a second portion of the antenna feed line;
an antenna feed line portion connected between the first port and the second port; and
monitoring circuitry adjacent the antenna feed line portion and configured to measure voltage of the antenna feed line.

2. An apparatus as claimed in claim 1, wherein the first port, the second port, the antenna feed line portion and the monitoring circuitry are arranged substantially in a first plane.

3. An apparatus as claimed in claim 2, wherein the first plane is substantially normal to both the first portion of the antenna feed line and the second portion of the antenna feed line.

4. An apparatus as claimed in claim 1, configured as a printed circuit board comprising the first port, the second port, the antenna feed line portion and the monitoring circuitry.

5. An apparatus as claimed in claim 4, wherein the printed circuit board extends along a first plane substantially normal to both the first portion of the antenna feed line and the second portion of the antenna feed line.

6. An apparatus as claimed in any preceding claim, configured for connection to an exterior portion of a housing of a filter.

7. An apparatus as claimed in any of claims 1 to 5, configured for connection to an exterior portion of a housing of a filter comprising filter cavities, wherein the first portion of the antenna feed line and the second portion of the antenna feed line lie in a second plane that transects the cavities of the filter.

8. An apparatus as claimed in claim 6 or 7, wherein the first port, the second port, the antenna feed line portion, and the monitoring circuitry adjacent the antenna feed line portion are located between the exterior portion of the housing of the filter and an isolating cover portion.

9. An apparatus as claimed in any preceding claim, wherein the monitoring circuitry comprises a coupler for measuring voltage of the antenna feed line dependent upon voltage standing wave ratio (VSWR).

10. A base station for radio communication comprising the apparatus as claimed in any preceding claim.

11. A base station as claimed in claim 10, wherein the first port, the second port, the antenna feed line portion, and the monitoring circuitry adjacent the antenna feed line portion are located within a vertical plane, in use.

12. A base station as claimed in claim 11, comprising a filter comprising manual tuning elements, arranged substantially in a horizontal plane.

13. A method of measuring voltage of the antenna feed line comprising:
placing a component in-line with the antenna feed line, wherein the component provides a portion of the antenna feed line and also provides monitoring circuitry adjacent the portion of the antenna feed line configured to measure voltage of the antenna feed line.
